# EUROPEAN PATENT APPLICATION

(11) **EP 2 323 015 A2**
(43) Date of publication of application: **18.05.2011**
(21) Application number: 10014508.5
(22) Date of filing: 11.11.2010
(51) Int. Cl.: G06F 3/02, H02K 35/02, H02K 57/00, H02N 11/00

(54) **Manual control device with power generation function and remote control device with power generation function**

(30) Priority: 11.11.2009 JP 2009257701
(71) Applicant: Renesas Electronics Corporation, Nakahara-ku Kawasaki Kanagawa 211-8668 (JP); Soundpower corporation, Kanagawa 252-0816 (JP)
(72) Inventor: Ozawa, Naofumi, Kanagawa 211-8668 (JP); Gunji, Takahisa, Kanagawa 211-8668 (JP); Kimura, Toshio, Kanagawa 211-8668 (JP); Hayamizu, Kohei, Kanagawa 252-0816 (JP)
(74) Representative: Glawe, Delfs, Moll

(57) **Abstract**

A manual control device with a power generation function includes a manual input unit of a touch sensor type, a control unit that detects a direction input in the manual input unit and performs a control operation according to the direction, a power generation unit that is formed of piezoelectric material for power generation and arranged to a bottom side of the manual input unit, a charge unit that charges electric power from the power generation unit, and a power supply unit that supplies the electric power from the charge unit to the control unit. The operation start control unit supplies an operation instruction to the power supply unit after predetermined delay time since the electric power supply from the power generation unit to the charge unit is detected.

## Description

### INCORPORATION BY REFERENCE

This application is based upon and claims the benefit of priority from Japanese patent application No. 2009-257701, filed on November 11, 2009, the disclosure of which is incorporated herein in its entirety by reference.

### BACKGROUND

### 1. Field of the Invention

The present invention relates to a manual control device with a power generation function and a remote control device with a power generation function. In particular, the present invention relates to a manual control device with a power generation function and a remote control device with a power generation function that uses electromotive force by piezoelectric effect. For example, the present invention relates a remote controller with a power generation function.

### 2. Description of Related Art

In recent years, growing awareness of ecology leads to the trend towards devices with a small environmental impact.

Further, it is desired to reduce the maintenance load.

From such a point of view, many devices using natural energy such as sunlight, vibration, and heat, have been suggested.

Batteries are generally used in a remote device, however it is desired to eliminate the maintenance of replacing the batteries and also to reduce the environmental impact.

For example, a remote control device incorporating an electromotive device using piezoelectric material is disclosed in Japanese Unexamined Patent Application Publication No. 2003-224315.

Fig. 12 illustrates a configuration of a first exemplary embodiment of Japanese Unexamined Patent Application Publication No. 2003-224315.

In this configuration, a piezoelectric spring 5 is arranged to each key input button 6. The stress of a user keystroke on the key 6 deforms the piezoelectric spring 5. Then, electromotive force is generated. An electronic circuit is driven by this electromotive force.

Fig. 13 illustrates a configuration of a second exemplary embodiment disclosed in Japanese Unexamined Patent Application Publication No. 2003-224315.

In this configuration, a remote control device includes a piezoelectric plate 25 with a plurality of buttons 26 provided to the top surface thereof, and a switch 28 provided to the position corresponding to the button 26 immediately under the piezoelectric plate 25.

A press of the button 26 deforms the piezoelectric plate 25, and generates electromotive force in the piezoelectric plate 25. This electromotive force is transmitted to an electronic circuit from a supply unit 25a. When the piezoelectric plate 25 is deformed by the press of the button 26, the switch 28 under the piezoelectric plate is pressed. The electric circuit detects the press of the button, and a predetermined operation is performed corresponding to the button action.

### SUMMARY

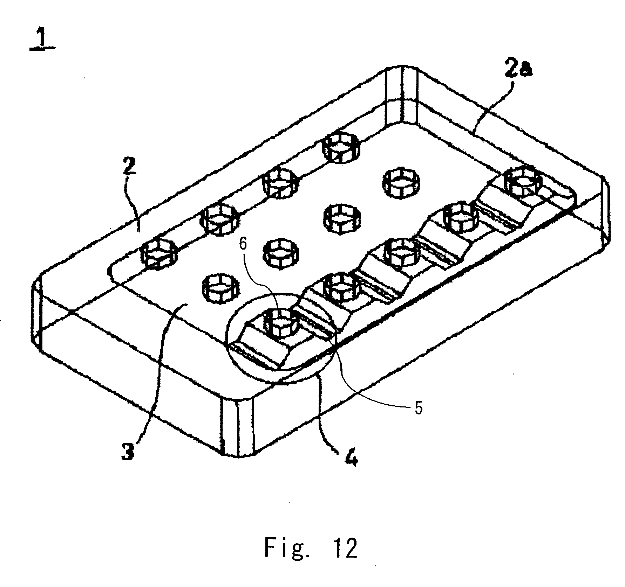

However, in the above first exemplary embodiment (Fig. 12) of Japanese Unexamined Patent Application Publication No. 2003-224315, the piezoelectric spring 5 that deforms is extremely small for a key operation. It is quite difficult to obtain enough amount of electric power generation if the piezoelectric element, which is an electromotive unit, is small. Accordingly, the abovementioned configuration of the first exemplary embodiment (Fig. 12) of Japanese Unexamined Patent Application Publication No. 2003-224315 is not realistic as a configuration of an electronic equipment with a power generation function.

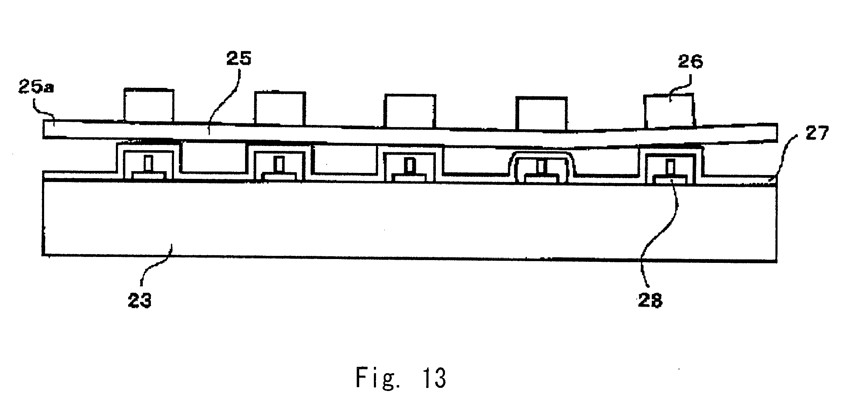

In the configuration of the second exemplary embodiment (Fig. 13) of Japanese Unexamined Patent Application Publication No. 2003-224315, the amount of deformation of the piezoelectric plate 25 when a user presses the button 26 is mainly determined by a stroke of the switch 28. Thus there is a problem that the amount of deformation of the piezoelectric plate 25 is small.

It can be considered that the user presses the button 26 harder to largely deform the piezoelectric plate 25.

However, when the user has the feel of pressing the switch 28 on the user finger, it is less common for the user to press the button 26 harder.

The user usually releases the finger from the button 26 when the user has the feel of button operation. Further, the user applies only appropriate pressure for the click pressure of the button 26.

Accordingly, the piezoelectric plate 25 will not be pressed more than the stroke of the switch 28, and the deformation of the piezoelectric plate 25 will be small.

Therefore, enough amount of generated electric power cannot be obtained from the piezoelectric plate.

Furthermore electromotive force from the piezoelectric plate 25 is generated not only at the time of pressing the button 26 but at the time of restoration after releasing the user finger from the button 26.

However, in the abovementioned first and the second exemplary embodiments of Japanese Unexamined Patent Application Publication No. 2003-224315, the electric power generated at the time of restoration of the piezoelectric plate 25 is not used at all.

In order to use the electromotive force generated when the piezoelectric plate 25 is restored, it is necessary to start the electronic circuit after the piezoelectric plate is restored. However by delaying the startup of the electronic equipment, the press of the switch 28 cannot be detected. This is because that the switch 28 is also restored when the piezoelectric plate 25 is restored. Therefore, the present inventors have found a problem that there is a high possibility that in the configuration disclosed in Japanese Unexamined Patent Application Publication No. 2003-224315, the device becomes inoperative due to power shortage in an actual operation.

An exemplary aspect of the present invention is a manual control device with a power generation function including a manual input unit of a touch sensor type, a control unit that detects a direction input in the manual input unit and performs a control operation according to the direction, a power generation unit that is formed of piezoelectric material for power generation and arranged to a bottom side of the manual input unit, a charge unit that charges electric power from the power generation unit, and a power supply unit that supplies the electric power from the charge unit to the control unit.

In such a configuration, as the input unit is formed as a touch sensor, a user input command can be detected as long as the user finger touches the input unit. The input command can be detected after the user eases the pressure on the finger, thus the circuit operation can be started after the electric power is generated by restoration of the power generation unit. By setting the start timing of the circuit operation to after restoring the power generation unit, the control unit can start the operation after enough electric power is stored in the charge unit. Then the control unit can stably operate by stable power supply.

Moreover, it is possible to use the electric power generated by two vibrations (deformation and restoration) from one press operation by the user. Therefore, the size of the power generation unit can be half the size thereof when using the electric power generated by only one vibration.

### BRIEF DESCRIPTION OF THE DRAWINGS

The above and other exemplary aspects, advantages and features will be more apparent from the following description of certain exemplary embodiments taken in conjunction with the accompanying drawings, in which:

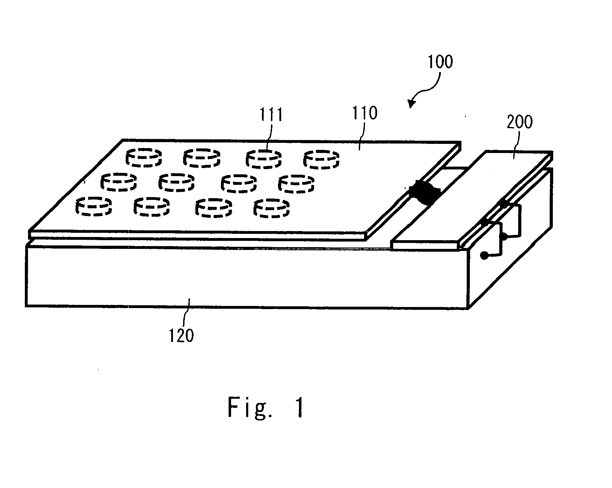

Fig. 1 illustrates a remote control device (manual control device) 100 according to a first exemplary embodiment;

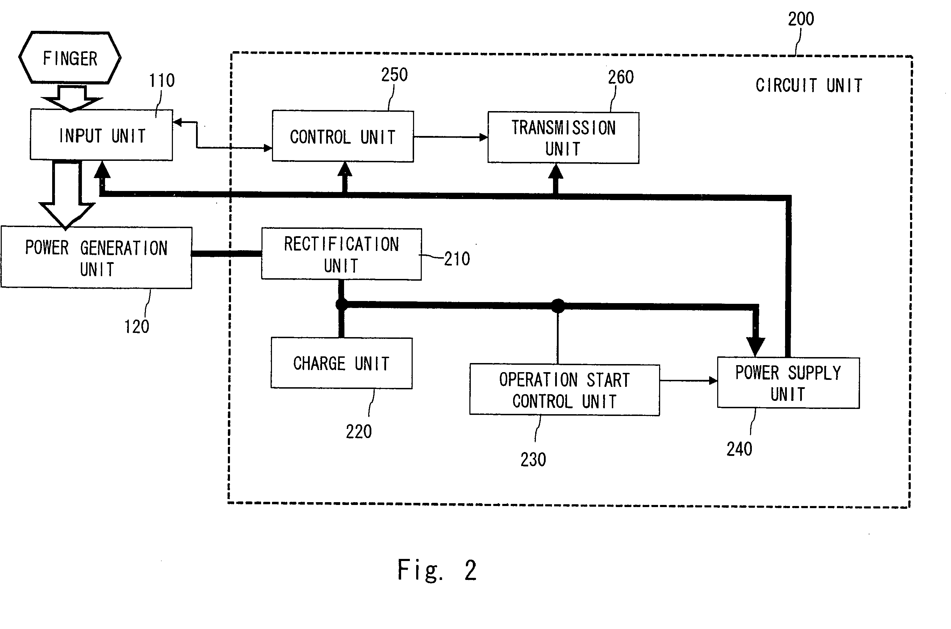

Fig. 2 is a functional block diagram of the remote control device 100;

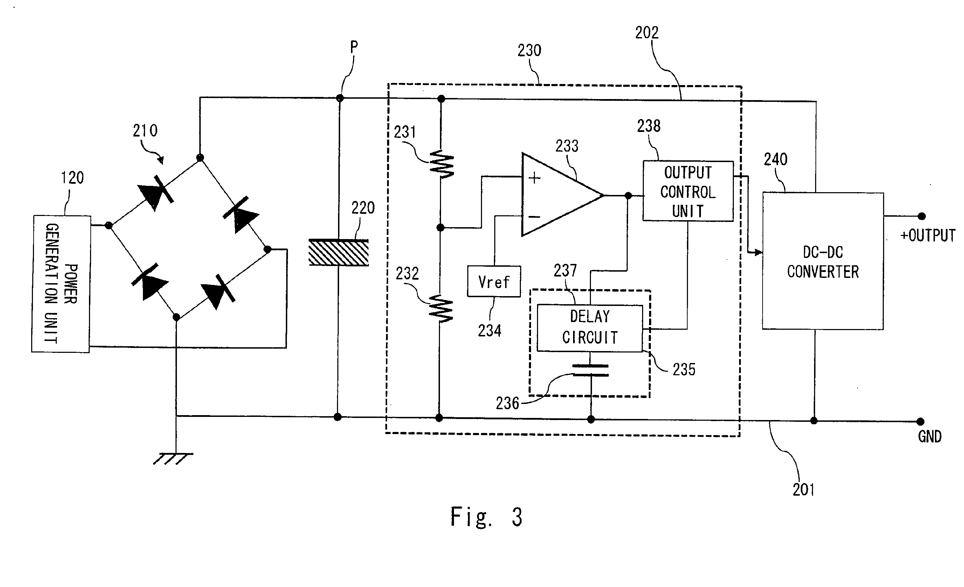

Fig. 3 is a circuit diagram from a power generation unit 120 to a power supply unit 240;

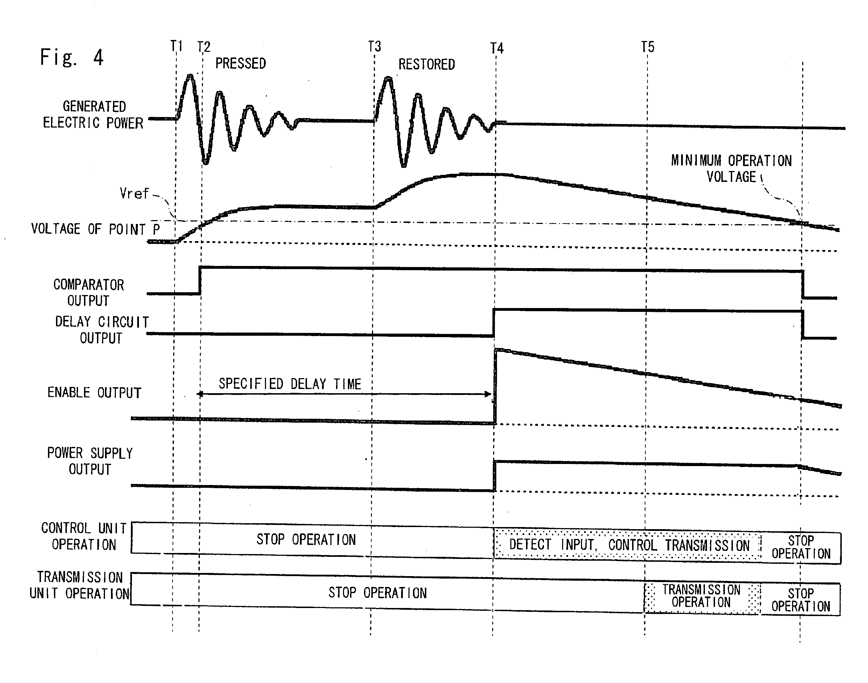

Fig. 4 is a timing chart for explaining an operation of the remote control device 100;

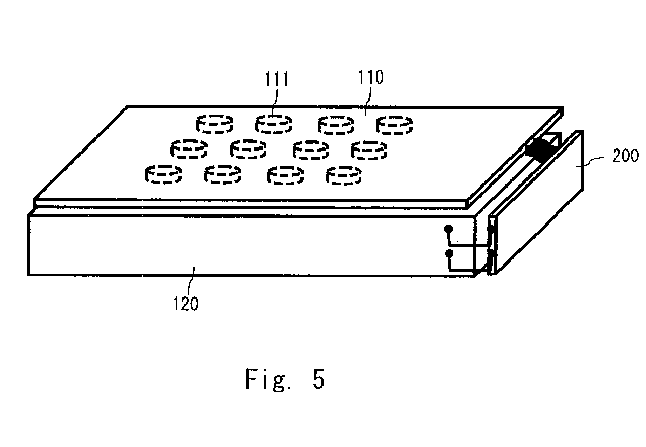

Fig. 5 illustrates a modification 1;

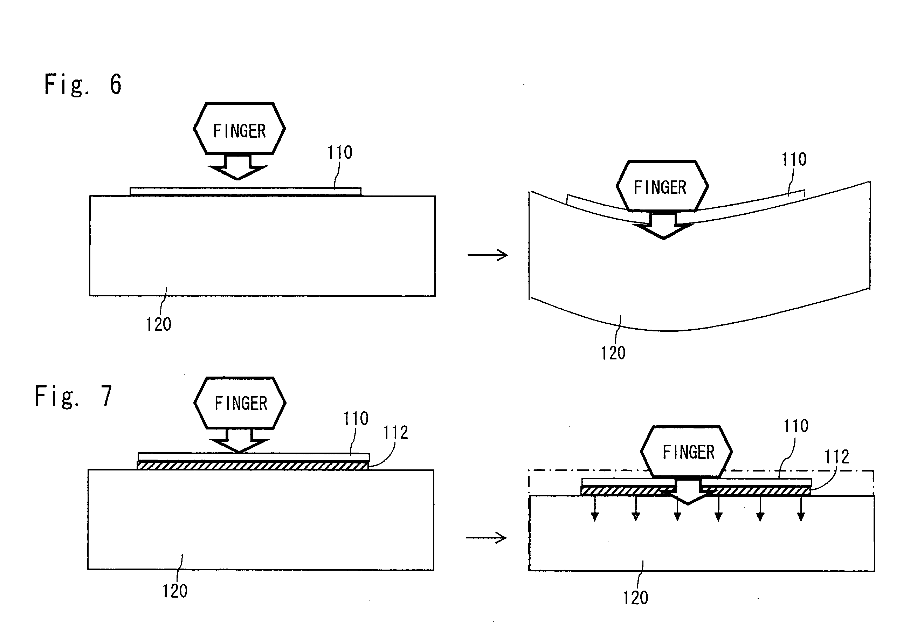

Fig. 6 illustrates a modification 2;
Fig. 7 illustrates the modification 2;

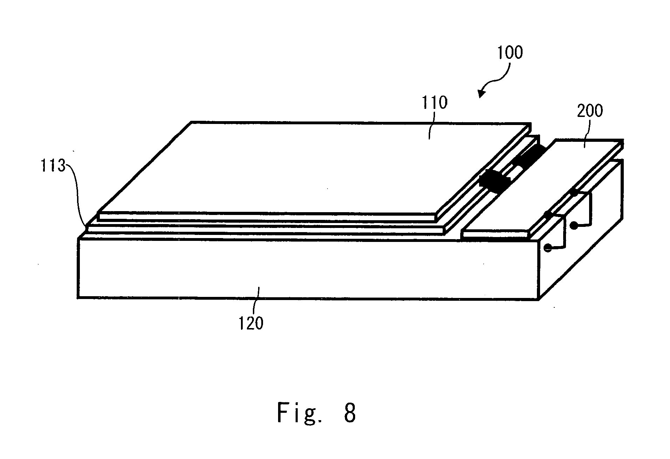

Fig. 8 illustrates a second exemplary embodiment;

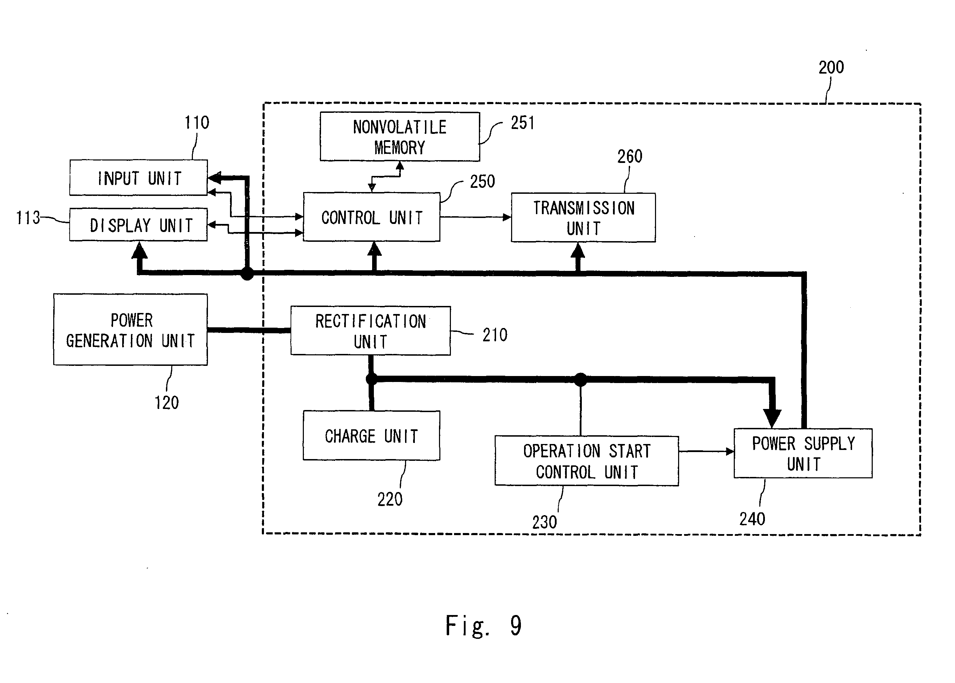

Fig. 9 is a functional block diagram of the second exemplary embodiment.

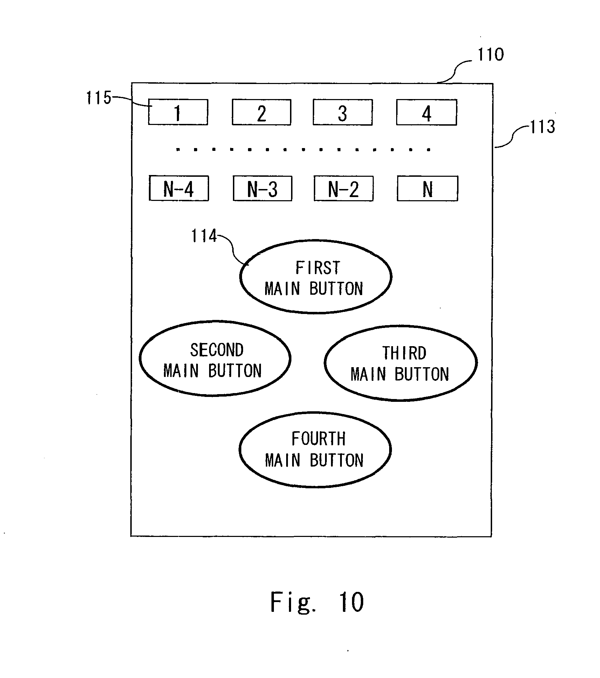

Fig. 10 illustrates a display example;

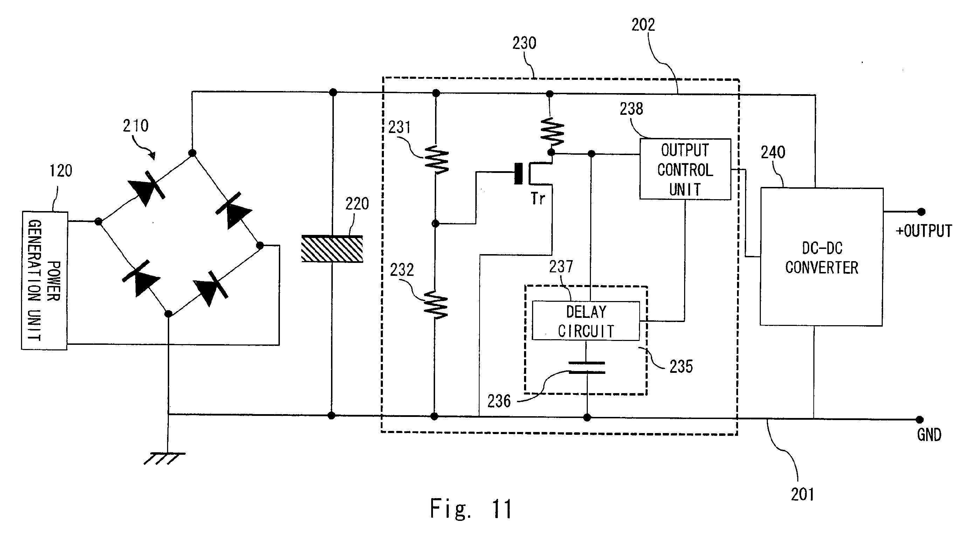

Fig. 11 illustrates a modification;
Fig. 12 illustrates a configuration of a first exemplary embodiment disclosed in Japanese Unexamined Patent Application Publication No. 2003-224315; and
Fig. 13 illustrates a configuration of a second exemplary embodiment disclosed in Japanese Unexamined Patent Application Publication No. 2003-224315.

### DETAILED DESCRIPTION OF THE EXEMPLARY EMBODIMENTS

Hereinafter, exemplary embodiments of the present invention are described with reference to the drawings.

### [First exemplary embodiment]

Fig. 1 illustrates a configuration of a remote control device (manual control device) 100 according to a first exemplary embodiment.

The remote control device 100 includes an input unit 110, a power generation unit 120, and a circuit unit 200.

The input unit 110 is a touch sensor type input device.

The configuration of the touch sensor is not especially limited, as long as it is a sheet-like touch sensor that can detect a region touched by a user finger.

A plurality of buttons 111 are printed on a surface part of the touch sensor.

A letter, a symbol, or the like are placed to each button 111. Each button 111 corresponds to a predetermined command.

Note that the button 111 here simply means a mark indicating a region corresponding the command, and does not mean a physical switch device that functions as a detection device.

The power generation unit 120 converts applied force into voltage.

The power generation unit 120 includes a piezoelectric element composed of an electrode and a piezoelectric body (piezoelectric material for power generation).

The arrangement structure of the piezoelectric element in the power generation unit is not especially limited as long as the applied force can be converted into voltage. For example, a plurality of piezoelectric elements may be stacked to form a stack. Alternatively, a plurality of piezoelectric elements may be arranged over a vibrating plate formed of flexible material, and deformation of the vibrating plate causes the piezoelectric element to generate electric power.

The arrangement and the size of the input unit 110 and the power generation unit 120 are explained here.

The power generation unit 120 is placed to a bottom surface side of the touch sensor style input unit 110. When a user presses the button 111 of the input unit 110 using a finger, the power generation unit 120 of the bottom surface is pressed together with the touch sensor input unit 110.

The power generation unit 120 is not separated and divided by each button 111, but the integrated power generation unit 120 exists under the touch sensor input unit 110.

In a plan view from above, the size of the power generation unit 120 is greater than at least one of the size of the buttons 111. Then, pressing force applied to the power generation unit 120 deforms the entire power generation unit.

The bottom surface side of the input unit 110 is set aside as a space to place only the power generation unit 120.

The size of the power generation unit 120 is equal to or greater than that of the input unit 110 in the plan view from above, with enough thickness.

In Fig. 1, for the size of the top surface of the power generation unit 120, about 4/5 is the region to place the touch sensor input unit 110, and about 1/5 is the region to place the circuit unit 200.

Fig. 2 is a functional block diagram of the remote control device 100.

The circuit unit 200 includes a rectification unit 210, a charge unit 220, an operation start control unit 230, a power supply unit 240, a control unit 250, and a transmission unit 260.

Fig. 3 is a circuit diagram from the power generation unit 120 to the power supply unit 240.

The electric power is generated in the power generation unit 120, rectified in the rectification unit 210, and stored to the charge unit 220.

The operation start control unit 230 supplies an operation start instruction to the power supply unit 240.

The operation start control unit 230 includes two voltage dividing resistors 231 and 232, a comparator 233, a delay control unit 235, and an output control unit 238, which are provided between a ground line 201 and a voltage line 202.

The comparator 233 outputs H level when the voltage divided by the voltage dividing resistors 231 and 232 exceeds a reference voltage Vref.

The reference voltage Vref is generated in a reference voltage generation circuit 234.

A Zener diode is used as an element for the reference voltage generation circuit 234 that generates the reference voltage.

The element of the reference voltage generation circuit may not necessarily be a Zener diode, but may be a rechargeable secondary battery, for example, which is charged by the charge unit 220.

The delay control unit 235 includes a delay time setting capacitor 236 and a delay circuit 237.

The delay time setting capacitor 236 is provided between the ground line 201 and a comparator output line.

When the H level is output from the comparator 233, the electric power is charged to the capacitor 236 of the delay control unit 235.

The delay time is determined by the size of the capacitor 236.

It is preferable to specify the delay time to common elapsed time since when the user starts pressing the button until eases the pressure on the user finger.

The delay circuit 237 supplies a signal to the output control unit 238 when a predetermined voltage is charged to the capacitor 236 and exceeds a predetermined threshold. Then, the output control unit 238 outputs H level of an enable signal to the power supply unit 240.

The power supply unit 240 is a DC-DC converter, and starts an operation in response to the enable signal output from the operation start control unit 230. Accordingly, when the enable signal is L level, the power supply unit 240 maintains the state to suspend the power supply.

If the enable signal becomes H level, the power supply unit 240 converts the electric power accumulated in the charge unit 220 into the predetermined voltage and starts the power supply.

The control unit 250 detects the command output from the input unit 110, and performs a control process according to the command. For example, the control unit 250 generates transmit data corresponding to the command, and transmits the data to the transmission unit 260.

The transmission unit 260 transmits the transmit data supplied by the control unit 250.

Fig. 4 is a timing chart for explaining the operation of the remote control device 100.

The operation of the remote control device 100 is explained with reference to Fig. 4.

A user starts the press operation on the button 111 of the touch sensor input unit 110 at the time T1.

At this time, the force to press the button 111 also presses the power generation unit 120, and thereby generating electric power in the power generation unit 120.

The rectification unit 220 stores the generated electric power to the charge unit 220 via the rectification unit 210.

Further, if a connection node of the voltage line 202 and the charge unit 220 is referred to as a point P, the voltage of this point P will be increased.

The comparator 233 compares the voltage of the point P, which is divided by the voltage dividing resistors, with the reference voltage Vref.

The comparator 233 outputs H level when the voltage divided by the voltage dividing resistor exceeds the reference voltage Vref (at the time 2).

When H level is output from the comparator 233, the electric power is stored to the capacitor 236. However a signal is not output from the delay circuit 237 till the delay time specified by the capacitor 236.

The user presses the button 111, and then starts to ease the pressure on the finger when the user feels that a predetermined input is completed (at the time T3). Then, the power generation unit 120 is restored and the electric power is generated at this time. The generated electric power is also stored to the charge unit 220.

The specified delay time of the capacitor 236 is reached at about when the power generation unit 120 is restored, and the delay circuit 237 supplies the signal to the output control unit 238 (at the time T4). Then, H level of the enable signal is output to the power supply unit 240 from the output control unit 238.

In response to the H level of the enable signal, the power supply unit 240 starts to supply power.

In response to the start of power supply, the control unit 250 performs input evaluation of the input unit 110. Specifically, the control unit 250 evaluates which button of the touch sensor input 110 is touched by the user finger.

Even if the user eases the pressure on the finger, the touch sensor input unit 110 can detect the contact position as long as the user finger touches the touch sensor.

The control unit 250 generates data according to the directed command, and transmits the data to the transmission unit 260. Then, the transmission unit 260 transmits the transmit data.

For example, a user direction is supplied to devices such as a television and an air-conditioner.

The control unit 250 and the transmission unit 260 stop the operation when the data transmission from the transmission unit 260 is completed.

The first exemplary embodiment with such a configuration produces the following exemplary advantages.
(1) Since the input unit 110 is formed as a touch sensor, a user input command can be detected as long as the user finger is touching the input unit 110.

Accordingly, the user input command can be detected even when the user eases the pressure on the finger after pressing the input unit 110.

As the input command can be detected even after the user eases the pressure on the finger, the circuit operation may be started after the electric power is generated by the restoration of the power generation unit 120.

By setting the start timing of the circuit operation to after the restoration of the power generation unit 120, the circuit unit 200 can start the operation after enough electric power is stored to the charge unit.

Therefore, the circuit unit 200 can stably operate by stable power supply.

As described so far, it is possible to use the electric power generated by two vibrations (deformation and restoration) from one press operation by the user. Therefore, the size of the power generation unit 120 can be half the size thereof when using the electric power generated by only one vibration.
(2) According to this exemplary embodiment, as the input unit 110 is formed of a simple sheet-like member, which is a touch sensor, the bottom surface side of the input unit 110 can be set aside as a space to place only the power generation unit 120.

In the configuration disclosed in Japanese Unexamined Patent Application Publication No. 2003-224315, there are many components and the configuration is complicated, such that the piezoelectric spring is provided for each button, and the button and a mechanical switch sandwich the piezoelectric board.

Therefore, the size of the piezoelectric material, which is the power generation unit, cannot be increased.

In this regard, in this exemplary embodiment, the size of the power generation unit 120 can be increased enough, and thereby achieving sufficient electric power for the circuit operation.
(3) By forming the input unit 110 as a touch sensor, a press stroke is not necessary unlike the mechanical switch, for example.

Since the user does not have a click feeling like the mechanical switch, the user presses the finger on the touch sensor input unit 110 harder and longer, and thus the power generation unit 120 of the bottom surface side is pressed harder accordingly.

Thus, the amount of electric power generated in the power generation unit 120 increases.

### (Modification 1)

A modification 1 is explained hereinafter.

Fig. 5 illustrates the modification 1.

In the above first exemplary embodiment, the touch sensor input unit 110 and the circuit unit 220 are arranged to the top surface side of the power generation unit 120.

On the other hand, in the modification 1, the circuit unit 200 is arranged to the side surface side of the power generation unit 120, and the entire top surface of the power generation unit 120 is a region to arrange the input unit 110.

As the entire top surface of the power generation unit 120 can be the input unit 110, the button 111 can be placed to the central region of the power generation unit 120.

Thus, the central region of the power generation unit 120 is pressed harder at the time of button operation by a user, and thereby further increasing the amount of deformation of the power generation unit 120. Accordingly, a greater amount of electric power generation can be obtained.

### (Modification 2)

The touch sensor type input unit 110 may be formed of flexible material, such as a resin film.

In such case, if the user presses the touch sensor input unit 110, both the touch sensor input unit 110 and the power generation unit 120 bend and deform as shown in Fig. 6.

If the button 111 is placed to the central region, little pressure is needed to bend and largely deform the power generation unit 120.

Alternatively, as illustrated in Fig. 7, plate material 112 having stiffness such as an organic glass and a plastic plate may be arranged to the bottom surface of the touch sensor type input unit 110.

In such a case, when the user presses the touch sensor input unit 110 with a finger, the entire plate material 112 presses down the power generation unit 120. Thus the power generation unit 120 shrinks as compressed from above.

As the plate material 112 evenly presses down the top surface of the power generation unit 120, the power generation unit 120 can be deformed regardless of the position of the button 111.

### [Second exemplary embodiment]

Next, a second exemplary embodiment of the present invention is described.

The second exemplary embodiment is characterized in the point that a display unit 113 is included to the bottom surface side of the touch sensor input unit.

Fig. 8 illustrates the second exemplary embodiment.

The display unit 113 is provided between the touch sensor input unit 110 and the power generation unit 120.

The display unit 113 is a nonvolatile display panel.

The nonvolatile display panel does not need energy (electric power) to maintain the display state.

In a case of a liquid crystal display panel, a panel can be used which uses strong dielectric liquid crystals that spontaneously polarize even with zero external voltage.

The input button is displayed on the display unit 113.

Accordingly, the touch sensor input unit 110 does not need the button region and the print of letters and symbols.

However, the touch sensor input unit 110 must be light transmissive.

Fig. 9 is a functional block diagram of the second exemplary embodiment.

In Fig. 9, a rewritable nonvolatile memory 251 is added to the control unit 250.

The nonvolatile memory 251 stores an input menu displayed on the display unit 113.

The control unit 250 controls the display content of the display unit 113, and saves the display content to the nonvolatile memory 251 every time the display content of the display unit 113 is switched.

Fig. 10 illustrates a display example.

The display unit 113 displays main buttons 114 in which a user mainly uses, and sub-buttons 115 in which the user supplementarily uses for changing a function or the like.

In Fig. 10, four main buttons 114 are arranged to a central region, and N sub-buttons 114 are arranged to the upper edge part.

The user specifies often-used command to the main button 114.

For example, suppose that the user attempts allocate the content of the function N-1 to the first main button 114.

The user simultaneously touches the first main button 114 and the sub-button 115 of function N-1.

When the control unit 250 detects that the first main button 114 and the sub-button 115 of the function N-1 are simultaneously pressed, the control unit 250 changes the command content of the first main button 114 to the function N-1, and updates the display on the display unit 113. Then, the control unit 250 saves such function setting to the nonvolatile memory 251.

After that, the user can press the first main button 114 to input the command of the function N-1.

The second exemplary embodiment brings the following exemplary advantages.

In the remote control device 100 of self-power-generation type does not supply enough electric power to the circuit unit 200 when not used.

In this regard, in the second exemplary embodiment, the nonvolatile display unit 113 can maintain the display even when the electric power is not supplied.

Further, as the electric power is generated by a user finger press, the button must be the one to make the user strongly press the button.

Small button display might leads to a light touch, thus larger button display than a ball of a finger is desired in order for the user to press hard using with the ball of the finger..

Accordingly, the number of buttons is limited in order to make the user press the button harder.

In this regard, in the second exemplary embodiment, four of the large buttons 114 in which the user mainly presses are arranged to the central region.

By placing large main buttons 114 to the central region in this way, it is possible to make the user press the button hard, and thus obtaining enough amount of generated electric power.

Furthermore, as the command content of the main button 114 can be switched, it is possible to handle many kinds of command operations.

### (Example 1)

One example is illustrated hereinafter.

As a result of an experiment using a power generation unit with the same size as a common remote control, a capacitor of 47 µF can be charged to 4.4 V in one press operation.

This electric power drives 10 mA load for 10 ms.

The present invention is not limited to the above exemplary embodiments, but may be changed without departing from the scope of the present invention.

The case is explained in which the operation start control unit supplies the enable signal to the power supply unit after the delay time which is delayed by the delay time setting capacitor. However, the following case can be possible.

The reference voltage Vref is specified as a reference voltage level necessary for the circuit operation, and when the comparator detects that the voltage level of the point P exceeds the reference voltage level, the enable signal is output.

In this case, the delay time control unit is unnecessary.

The above exemplary embodiments illustrate the example in which the reference voltage generation unit generates the reference voltage, and the comparator compares the reference voltage with the voltage of the point P. However as illustrated in Fig. 11, start of the charge to the charge unit may be detected using a threshold voltage of a transistor Tr.

The first and second exemplary embodiments can be combined as desirable by one of ordinary skill in the art.

While the invention has been described in terms of several exemplary embodiments, those skilled in the art will recognize that the invention can be practiced with various modifications within the spirit and scope of the appended claims and the invention is not limited to the examples described above.

Further, the scope of the claims is not limited by the exemplary embodiments described above.

Furthermore, it is noted that, Applicant's intent is to encompass equivalents of all claim elements, even if amended later during prosecution.

## Claims

1. A manual control device with a power generation function comprising:
a manual input unit of a touch sensor type;
a control unit that detects a direction input in the manual input unit and performs a control operation according to the direction;
a power generation unit that is formed of piezoelectric material for power generation and arranged to a bottom side of the manual input unit;
a charge unit that charges electric power from the power generation unit; and
a power supply unit that supplies the electric power from the charge unit to the control unit.

2. The manual control device with the power generation function according to Claim 1, further comprising an operation start control unit that supplies an operation instruction to the power supply unit after the electric power necessary for an operation of the control unit is charged to the charge unit.

3. The manual control device with the power generation function according to Claim 2, wherein the operation start control unit supplies the operation instruction to the power supply unit after predetermined delay time since the electric power supply from the power generation unit to the charge unit is detected.

4. The manual control device with the power generation function according to Claim 3, wherein
the operation start control unit includes a delay time setting capacitor, and
the delay time is specified by time to charge predetermined electric power to the delay time setting capacitor.

5. The manual control device with the power generation function according to Claim 2, wherein the operation start control unit supplies the operation instruction to the power supply unit when the operation start control unit detects that an amount of charged electric power in the charge unit reaches a predetermined value.

6. The manual control device with the power generation function according to Claim 2, wherein the control unit detects a region touched by a user finger after the user finger eases pressure on the finger to press the manual input unit.

7. The manual control device with the power generation function according to any of Claims 1 to 6, further comprising a nonvolatile display unit provided between the manual input unit and the power generation unit.

8. The manual control device with the power generation function according to Claim 7, further comprising a nonvolatile memory that stores a correspondence between a button displayed on the nonvolatile display unit and an input command specified to the button

9. A remote control device with a power generation function incorporating a radio wave transmission unit in the manual control device with the power generation function according to any of Claims 1 to 8.
